# EUROPÄISCHE PATENTSCHRIFT

(11) **EP 0 401 545 B1**
(45) Veröffentlichungstag und Bekanntmachung des Hinweises auf die Patenterteilung: **27.07.1994**
(21) Anmeldenummer: 90108970.6
(22) Anmeldetag: 12.05.1990
(51) Int. Cl.: H03L 5/02, H04B 1/04, H03G 3/20

(54) **Leistungsregelanordnung**
Power control arrangement
Agencement de régulation de la puissance

(30) Priorität: 03.06.1989 DE 3918159
(43) Veröffentlichungstag der Anmeldung: 12.12.1990
(73) Patentinhaber: Daimler-Benz Aerospace Aktiengesellschaft, 81663 München (DE)
(72) Erfinder: Esprester, Ralf, Dr.-Ing., D-7909 Dornstadt (DE); Kombrink, Friedemann, Ing.-grad., D-7907 Langenau (DE)
(74) Vertreter: Schulze, Harald Rudolf, Dipl.-Ing.

(56) Entgegenhaltungen:
- DE-A- 2 710 752
- US-A- 4 066 965
- US-A- 4 165 493
- US-A- 4 447 783

## Beschreibung

Die Erfindung betrifft eine Leistungsregelanordnung für Leistungsendstufen frequenzvariabler Sender nach dem Oberbegriff des Patentanspruchs 1.

Zum Schutz von Leistungsendstufen vor Überlastung durch von der Antenne reflektierte Leistung bei schlechter Anpassung ist es üblich, mittels einer Richtkoppleranordnung die auf der Antennenzuleitung vorlaufenden und rucklaufenden Wellen zu überwachen und erforderlichenfalls die Verstärkung der Leistungsendstufe zu reduzieren. Um bei räumlich dicht benachbarten weiteren Sendern, z.B. auf Schiffen, die im gleichen Frequenzbereich mit u.U. nur geringem Frequenzabstand betrieben werden, Störungen der Leistungsregelung mit Vor-und Rücklaufmessung zu vermeiden, sind in die Antennenleitung schmalbandige Sendefilter eingefügt. Da die Sendefrequenz variabel ist, müssen auch diese Filter durchstimmbar sein und automatisch auf die jeweilige Sendefrequenz abgestimmt werden. Diese Sendefilter, über die die gesamte Sendeleistung fließt, sind aber sehr aufwendig und können den Hauptteil der Kosten einer Sendeanlage beanspruchen.

Eine Anordnung, die diese Problematile benicksichtigt, ist aus DE-A-2 710 752 bekannt.

Der Erfindung liegt die Aufgabe zugrunde, eine Leistungsregelanordnung der im Oberbegriff des Patentanspruchs genannten Art anzugeben, welche ohne die Sendefilter eine störsichere Leistungsregelung ermöglicht.

Die Erfindung ist im Patentanspruch 1 beschrieben. Die Unteransprüche enthalten vorteilhafte Ausgestaltungen und Weiterbildungen der Erfindung.

Die erfindungsgemäße Anordnung ermöglicht eine hochselektive Trennung der vom Sendesignal herrührenden Anteile von Fremdsignalanteilen in den vor- und rücklaufenden Wellen bzw. den daraus ausgekoppelten Spannungen und den bei der Quadraturumsetzung erzielten Mischprodukten. Wesentlich ist, daß die Überlagerungssignale aus dem Sendesignal vor der Endstufe abgeleitet sind und daß die Entkopplung zwischen Ein- und Ausgangssignal ausreichend ist.

Die Erfindung ist nachfolgend anhand von Ausführungsbeispielen unter Bezugnahme auf die Abbildungen noch eingehend veranschaulicht. Dabei zeigt
- FIG. 1: ein Blockschaltbild einer Gesamtanordnung zur Leistungsregelung
- FIG. 2: eine Alternative unter Einsatz digitaler Mittel
- FIG. 3: den Selektionsverlauf der Anordnung
Bei der in der Abbildung skizzierten Senderanordnung wird in einer Sendesignalaufbereitungseinrichtung SA ein Sendesignal SE nach Frequenz und Modulation erzeugt und der Senderleistungsendstufe E zugeführt.

Das von der Endstufe verstärkte Sendesignal gelangt über einen Richtkoppler RK, die Antennenzuleitung L und ein Impedanzanpaßgerät APG zur Antenne A. In der Regel wird ein Teil der der Antenne zugeführten Sendeleistung wegen nicht perfekter Impedanzanpassung reflektiert und läuft über das Anpaßgerät, die Antennenzuleitung und den Richtkoppler zurück zur Leistungsendstufe E. Der Richtkoppler RK koppelt aus der Antennenzuleitung Spannungen U_{V} und U_{R}, die den von der Endstufe zur Antenne bzw. umgekehrt laufenden Wellen proportional sind, aus. Während die vorlaufenden Wellen im wesentlichen durch die von der Leistungsendstufe abgegebene Sendeleistung gebildet sind, setzen sich die rücklaufenden Wellen aus den an der Antenne reflektierten Anteilen und aus über die Antenne aufgenommenen Fremdsignalen zusammen, so daß die Spannung U_{V} proportional der Ausgangsleistung der Endstufe und die Spannung U_{R} proportional der Summe von reflektierter Leistung und Empfangsleistung von Fremdsignalen ist.

Vor der Endstufe E werden aus dem Sendesignal SE zwei Überlagerungssignale SI und SQ abgeleitet, die gleichfrequent zu dem Sendesignal SE sind und einen gegenseitigen Phasenunterschied von 90° aufweisen. Hierzu ist ein Differenzphasenglied PD, welches auch zusätzlich einen Verstärker enthalten kann vorgesehen, welches ein erstes Überlagerungssignal SI mit einer Phasenlage φ und ein zweites Überlagerungssignal SQ mit einer Phasenlage φ +90° erzeugt, wobei die absolute Phasenlage durch die nachfolgende Quadraturverarbeitung ohne Einfluß auf das Ergebnis ist und daher auch frequenzabhängig variieren kann.

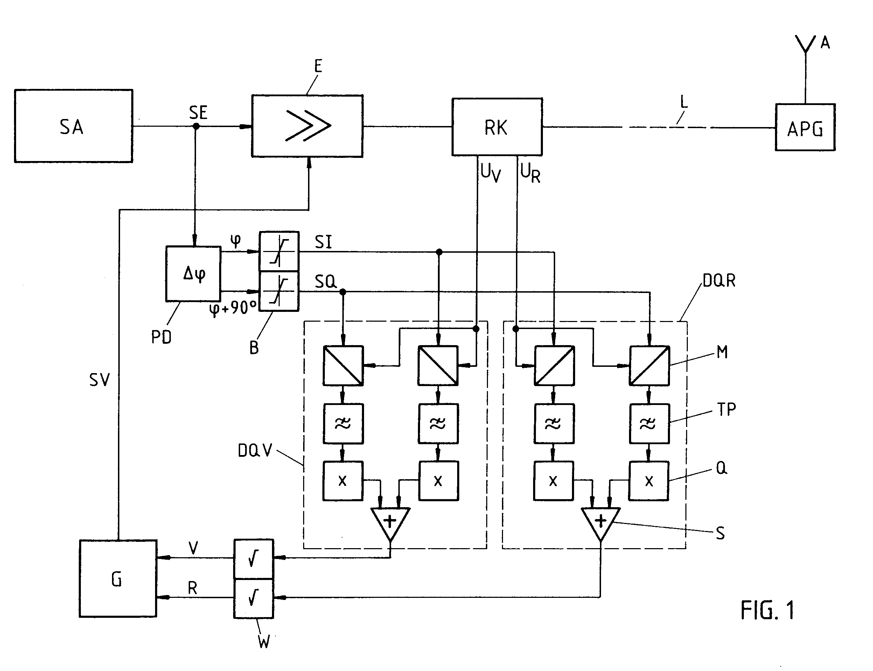

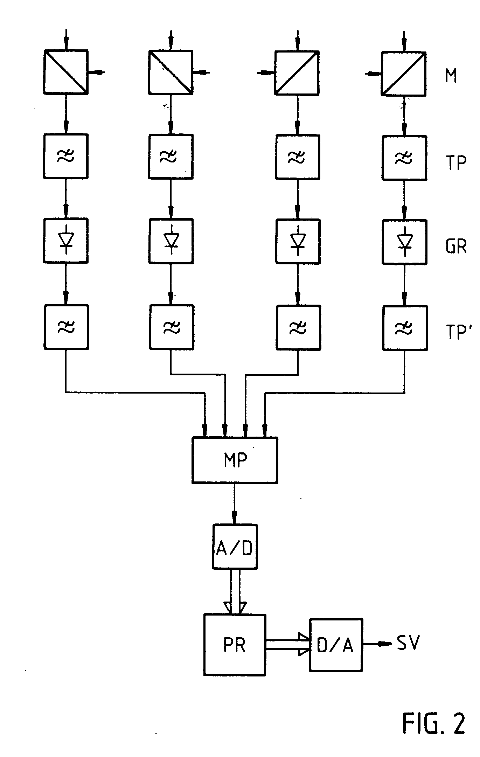

Für jede der beiden über den Richtkoppler Rk ausgekoppelten Spannungen U_{V} und U_{R} ist eine Quadraturamplitudendemodulatoranordnung DQV bzw. DQR vorgesehen. In Mischern M, die vorteilhafterweise als Ringmischer bzw. sogenannte Double-Balanced-Mischer ausgeführt sind, werden beide Spannungen U_{V}, U_{R} mit jedem der beiden Überlagerungssignale SI, SQ umgesetzt. Die Mischer arbeiten vorzugsweise im Schaltmodus und die Überlagerungssignale sind hierfür über Begrenzerverstärker B geführt. Aus den Mischerausgangssignalen werden mittels Tiefpaßfiltern TP auf Fremdsignale in der Antennenzuleitung zurückgehende Anteile unterdrückt. Gemäß dem Prinzip der Quadraturamplitudendemodulation werden die tiefpaßgefilterten Mischerausgangssignale in Quadriergliedern Q quadriert und je nach Zuordnung zu einer der beiden ausgekoppelten Spannungen U_{V} bzw. U_{R} getrennt die Quadratsummen in Summierern S gebildet. Aus diesen können durch Bilden der Quadratwurzeln in Radiziergliedern W die den Amplituden der auf der Antennenzuleitung vor- und rücklaufenden Wellen bei der jeweiligen Frequenz des frequenzvariablen Sendesignals SE proportionalen Vor- und Rücklaufsignale V und R gewonnen werden. Ein Regelsignalgenerator G leitet aus den Signalen V und R in im Prinzip bekannter Weise ein Regelsignal SV als Stellgröße für die Einstellung des Verstärkungsgrads der Leistungsendstufe E ab. Fremdsignale auf der Antennenzuleitung führen nicht zu einer Reaktion des Regelkreises.
Eine alternative Ausführungsform, die in FIG. 2 skizziert ist, sieht vor, die analogen Quadrier-, Summier- und Radizierglieder der Anordnung nach FIG. 1, die hinsichtlich Genauigkeit und des gegenseitigen Gleichlaufs (matching) u.U. Probleme bereiten können, durch digitale Signalverarbeitungseinrichtungen zu ersetzen. Hierzu werden die tiefpaßgefilterten Ausgangssignale der Mischer M über Einhüllendendetektoren GR und erforderlichenfalls weitere Tiefpaßfilter TP′ mittels eines Multiplexers MP zyklisch sukzessiv einem Analog/Digital-Umsetzer A/D zugeführt und digitalisiert. In einem Prozessor PR werden die digitalisierten Signale nach dem bei der Anordnung nach FIG. 1 beschriebenen Prinzip der Quadraturamplitudendemodulation weiterverarbeitet, wobei der Prozessor zweckmäßigerweise auch die Stellgröße SV zur Regelung des Verstärkungsgrads der Leistungsendstufe E festlegt und über einen Digital/Analog-Umsetzer als analoges Regelsignal ausgibt, oder direkt digital ansteuert (z.B. dann, wenn das Stellglied ein multiplizierender D/A-Wandler ist).

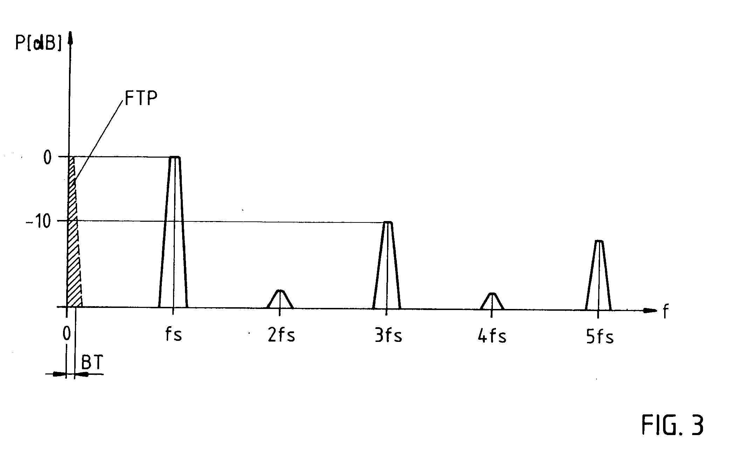

In FIG. 3 ist das Selektionsverhalten der Anordnung in prinzipieller Darstellung als relatives Pegelverhältnis in dB über der Frequenz aufgetragen, wobei mit fs die momentane Sendefrequenz bezeichnet sei. Der Selektionsverlauf ist im wesentlichen bestimmt durch die Filtercharakteristik FTP der Tiefpaßfilter und durch die Mischer M. Die Eintragungen in FIG. 3 sind entlang der Frequenzachse nicht maßstäblich, vielmehr liegt das Verhältnis der 3dB-Breite BT der Tiefpaßfiltercharakteristik FTP zu der Sendefrequenz fs typischerweise in der Größenordnung 10⁻³.

Die Selektionskurve zeigt Durchlaßbereiche bei ganzzahligen Vielfachen der Sendefrequenz fs, d.h., daß nur Fremdsignale mit innerhalb der Tiefpaßbandbreite bei f=n.fs (n ganzzahlig) die Vorlauf- und Rücklaufsignale V und R verfälschen können. Bei Verwendung von Ringmischern bzw. Double-Balanced-Mischern sind Fremdsignale bei geradzahligen Vielfachen der Sendefrequenz zudem weitestgehend unterdrückt, so daß erst Fremdsignale bei Dreifachen der Sendefrequenz nennenswerten Einfluß haben können. Durch die hochselektive Trennung ist die Wahrscheinlichkeit, daß zwei in enger Nachbarschaft angeordnete Sender genau ein solches Frequenzverhältnis aufweisen, aber äußerst gering. Zudem ist für Fremdsignale bei f=3fs in den Quadraturamplitudendemodulatoranordnungen auch bereits eine Dämpfung von ca. 10dB wirksam.

## Patentansprüche

1. Leistungsregelanordnung für Leistungsendstufen frequenzvariabler Sender, bei welcher über eine Richtkoppleranordnung den auf der Antennenzuleitung vorlaufenden und rücklaufenden Wellen proportionale Vorlauf- und Rücklaufspannungen (U_{V}, U_{R}) gewonnen und zur Ableitung einer Stellgröße (SV) zur Regelung der Verstärkung der Leistungsendstufe (E) herangezogen werden, dadurch gekennzeichnet, daß aus dem Sendesignal (SE) vor der Leistungsendstufe (E) zwei gleichfrequente, gegeneinander um 90° phasenverschobene Überlagerungssignale (SI, SQ) abgeleitet werden, daß die beiden aus der Antennenzuleitung (L) ausgekoppelten Spannungen (U_{V}, U_{R}) in je einer Quadraturamplitudendemodulatoranordnung (DQV, DQR) mit den beiden Überlagerungssignalen umgesetzt werden und die niederfrequenten Ausgangssignale der Demodulatoranordnung einer Einrichtung (G) zur Erzeugung der Stellgröße (SV) zugeführt sind.

2. Anordnung nach Anspruch 1, dadurch gekennzeichnet, daß die Überlagerungssignale über Begrenzverstärker (B) geführt sind.

3. Anordnung nach Anspruch 1 oder 2, dadurch gekennzeichnet, daß in den Quadraturamplitudendemodulatoranordnungen nach der Quadraturmischung und Tiefpaßfilterung der Mischerausgangssignale Mittel zur digitalen Erfassung der Amplituden der tiefpaßgefilterten Mischerausgangssignale enthalten und die digitalisierten Signale einem Signalprozessor zugeführt sind.

4. Anordnung nach Anspruch 3, dadurch gekennzeichnet, daß die genannten Mittel jeweils einen Einhüllenden-Detekor (GR), einen weiteren Tiefpaß (TP) sowie einen Analog/Digital-Umsetzer (A/D) enthalten.

5. Anordnung nach Anspruch 4, dadurch gekennzeichnet, daß für alle Signalpfade ein gemeinsamer Analog/Digital-Umsetzer vorhanden ist, der über einen Multiplexer mit den mehreren Signalpfaden zyklisch sukzessiv verbunden ist.

## Claims

1. Power-regulating arrangement for power output stages of transmitters of variable frequency, in which arrangement forward and return voltage (U_{V}, U_{R}) proportional to the forward and return waves on the aerial feed line are obtained by way of a directional coupling arrangement and drawn upon for the derivation of a control magnitude (SV) for the regulation of the amplification of the power output stage (E), characterised thereby, that two heterodyne signals (SI, SQ), which are of equal frequency and one displaced in phase relative to the other through 90°, are derived from the transmitted signal (SE) before the power output stage (E), that both the voltages (U_{V}, U_{R}) coupled out of the aerial feed line (L) are converted by both the heterodyne signals, each in a respective quadrature amplitude demodulator arrangement (DQV, DQR) and the low-frequency output signals of the demodulator arrangement are fed to an equipment (G) for the production of the control magnitude (SV).

2. Arrangement according to claim 1, characterised thereby, that the heterodyne signals are conducted by way of limiting amplifiers (B).

3. Arrangement according to claim 1 or 2, characterised thereby, that means for the digital detection of the amplitudes of the low-pass-filtered mixer output signals are contained behind the quadrature mixing and low-pass filtering of the mixer output signals in the quadrature amplitude demodulator arrangements and the digitised signals are fed to a signal processor.

4. Arrangement according to claim 3, characterised thereby, that the named means each time contain an envelope detector (GR), a further low-pass filter (TP) as well as an analog-to-digital converter (A/D).

5. Arrangement according to claim 4, characterised thereby, that a common analog-to-digital converter is present for all signal paths and connected by way of a multiplexer with the several signal paths in cyclical succession.

## Revendications

1. Agencement de régulation de la puissance pour étages de sortie d'émetteurs à fréquences variables, avec lequel on obtient, à travers un coupleur directif, les tensions d'aller et de retour (U_{V},U_{R}) proportionnelles aux ondes directes et récurrentes situées sur la conduite d'amenée de l'antenne et qui sont utilisées pour la dérivation d'une variable réglante (SV) pour la régulation de l'étage de sortie (E),
**caractérisé en ce que**
deux signaux superhétérodynes (SI, SQ) de même fréquence, déphasés de 90° l'un par rapport à l'autre, sont dérivés du signal d'émission (SE) en amont de l'étage de sortie (E), que les deux tensions (U_{V} U_{R}) découplées de la conduite d'amenée de l'antenne (L) sont déplacées respectivement dans un agencement démodulateur d'amplitude déphasé en quadrature (DQV, DQR) avec les deux signaux superhétérodynes et que les signaux de sortie à fréquence basse de l'agencement démodulateur sont transférés sur un dispositif (G) pour la génération de la variable (SV).

2. Agencement selon la revendication 1, caractérisé en ce que les signaux superhétérodynes traversent des amplificateurs limiteurs (B).

3. Agencement selon la revendication 1 ou 2, caractérisé en ce que dans les agencements démodulateurs d'amplitude déphasés en quadrature sont contenus en aval du mélange déphasé en quadrature et le filtrage passe-bas des moyens pour la saisie numérique des amplitudes des signaux de sortie du mélangeur filtrés passe-bas et les signaux numériques sont transférés à un processeur analogique.

4. Agencement selon la revendication 3, caractérisé en ce que les moyens cités contiennent respectivement un démodulateur enveloppant (GR), un autre passe-bas (TP) ainsi qu'un convertisseur analogique/numérique (A/D).

5. Agencement selon la revendication 4, caractérisé en ce que pour tous les cheminements de signaux on dispose d'un convertisseur analogique/numérique, relié successivement de façon cyclique à travers un multiplexeur avec les différents cheminements de signaux.
